# EUROPEAN PATENT APPLICATION

(11) **EP 1 679 753 A2**
(43) Date of publication of application: **12.07.2006**
(21) Application number: 05112825.4
(22) Date of filing: 22.12.2005
(51) Int. Cl.: H01L 51/10

(54) **Method for forming organic semiconductor layer and organic thin film transistor**

(30) Priority: 05.01.2005 JP 2005000549
(71) Applicant: KONICA MINOLTA HOLDINGS, INC., Tokyo 100-0005 (JP)
(72) Inventor: Hirai, Katsura c/oKonica Minolta Tech. Center Inc., 192-8505 Tokyo (JP); Tanaka c/oKonica Minolta Tech. Center Inc., 192-8505 Tokyo (JP); Takemura c/oKonica Minolta Tech. Center Inc., 192-8505 Tokyo (JP); Katakura c/oKonica Minolta Tech. Center Inc, 192-8505 Tokyo (JP); Sugisaki c/oKonica Minolta Tech. Center Inc, 192-8505 Tokyo (JP)
(74) Representative: Gille Hrabal Struck Neidlein Prop Roos

(57) **Abstract**

A method for forming an organic semiconductor layer especially for an organic thin film transistor in which a part of the organic semiconductive material thin film formed on a substrate is subjected to a pretreatment and then further subjected to a heating treatment.

## Description

### FIELD OF THE INVENTION

The present invention relates to a method for forming an organic semiconductor layer and an organic thin film transistor having the organic semiconductor layer.

### BACKGROUND OF THE INVENTION

Recently, various investigations have been developed on organic thin film transistor employing an organic semiconductor as the semiconductive channel. The organic semiconductor has an appeal for a thin film device since it has high affinity with a plastic substrate and is easier in manufacturing compared with the inorganic semiconductor.

Though the forming method for the organic semiconductor layer is typically a vapor deposition method, various methods can be applied according to the properties of the material. Among them, many trials are performed for easily forming the semiconductor layer by an ordinary pressure process or a wet process by coating or applying a solution or a liquid onto the substrate.

An organic semiconductor layer can be formed, for example, by coating and drying a solution of a π-conjugate soluble polymer such as polythiophene. In the method by simply coating and drying, however, problems are caused such as that the mobility in the formed semiconductor layer is low, fluctuation in the characteristics in the repeat of measurement and the threshold value of the gate voltage are high.

Consequently, strengthening of orientation of the semiconductive polymer by layer orientation is tried in Patent Document 1, for example. Moreover, Non-patent Document 1 describes trial to improve the electric field effect mobility of FET by strengthening the intermolecular staking or orientation of π-conjugate type polymer using a soluble organic semiconductor of thiophene polymer.

Patent documents 2, 3 and 4 each disclose an orientation treatment on the semiconductive polymer for raising the mobility of the semiconductor channel. The formation of the orientation, however, causes problems such as that treatment requires complicated operations and intricate constitutions of the semiconductor.

Accordingly, the thin film of organic semiconductive material having sufficient mobility, repeating stability and threshold voltage by the strengthened molecular orientation cannot be obtained yet by the formation of the organic semiconductor layer by simple method such as the coating of the organic semiconductive material.
Patent Document 1: Kokusai Koukai 01/47043, pamphlet
Patent Document 2: Tokkai Hei 9-232589
Patent Document 3: Tokkai Hei 7-206599
Patent Document 4: Kokusai Koukai 00/79617, pamphlet
Non-patent Document 1: JACS 2004, 126, 3378

### SUMMARY OF THE INVENTION

An object of the invention is to increase the carrier mobility in an organic semiconductor layer and to inhibit the property variation in the repeating of the measurement or use, to lower the threshold voltage and to improve the layer formation suitability of the organic semiconductor on the substrate.

An organic semiconductor layer can be formed by the invention, which has low threshold voltage, high carrier mobility, small characteristics fluctuation in repeating of measurement and good layer forming ability for forming layer with reduced defect.

### BRIEF DESCRIPTION OF THE PREFERRED EMBODIMENT

Fig. 1 shows an example of difference scanning calorimetric measurement of the organic semiconductor.
Figs. 2(a) to 2(f) each shows schematic drawings of examples of constitution of the organic thin film transistor.
Fig. 3 shows a schematic drawing of the equivalent circuit of the organic TFT sheet.

### DETAILED DESCRIPTION OF THE PREFERRED EMBODIMENT

Though the best embodiments for executing the invention are described below, the invention is not limited to the described embodiments.

The organic semiconductive material to be employed in the invention is a π-conjugate compound; the π-conjugate compound is a compound having a π-conjugate system in the molecule thereof and is capable of regularly orientating with another molecule for forming π-stacks. A low weight molecule compound, oligomer and polymer of such the compound are also employed in the invention. When the oligomer or the polymer of is employed as the organic semiconductive material, one having a weight average molecular weight of not larger than 5,000 is preferable. It is supposed that sufficient carrier mobility cannot be obtained by the large polymer molecules because the π-stacks are only partially formed and many portions in which the orientation is disordered are caused. The carrier mobility may be increased when the crystallized area is larger and the ratio of the crystallized area is higher.

Examples of the low molecular weight organic semiconductor having the foregoing molecular weight are pentathene and substituted pentathene compounds described in WO 03/28125, WO 03/16599, USP No. 6,690,029 and US 2003-136964, for example; which can be employed in the invention.

As the low molecular weight compound, a compound containing two or more heterocyclic rings in the molecular structure thereof is preferable, and a compound in which the heterocyclic ring is a thiophene ring is particularly preferable. Though the thiophene group may be either one having a substituent such as an alkyl group or one having no substituent, it is preferable that the thiophene group having a substituent is contained in the molecular. Furthermore, it is preferable that two or more thiophene rings are bonded with together in the molecular and the number of the thiophene rings is preferably from 2 to 10.

Polymers having the endothermic point and the exothermic point such as polyphenylenevinylene, polypyrrol and polythiophene can be employed in the invention. Among such the polymers, ones each having a weight average molecular weight of not more than 5,000 are preferable. Typically thiophene polymers described in JACS 2004, 126, 3378 can be cited.

Oligomers each having an average molecular weight of not more than 5,000 are preferable compounds in the invention for the organic semiconductive material. Thiophene oligomers are particularly preferably employed in the invention.

The thiophene oligomers preferably usable in the invention include a thiophene oligomer containing a repeating unit having a partial structure composed of at least two thiophene rings having a substituent and a repeating unit composed of at least two non-substituted thiophene rings, and the number of the thiophene ring is preferably from 8 to 20.

In the invention, the thiophene oligomers described in Toku-gan 2004-172317 filed on June 10, 2004, by the inventors can be preferably employed. Preferable thiophene oligomer is ones having the following partial structure represented by Formula 1.

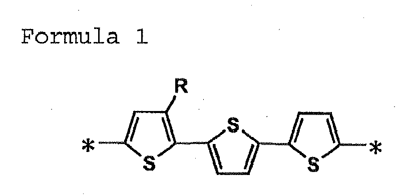

In the formula, R is a substituent.

### «Thiophene oligomer represented by Formula 1»

Thiophene oligomers represented by Formula 1 preferably employed in the invention are described below.

Examples of the substituent represented by R in Formula 1 include an alkyl group such as a methyl group, an ethyl group, a propyl group, an isopropyl group, a tert-butyl group, a pentyl group, a hexyl group, an octyl group, a dodecyl group, a tridecyl group, a tetradecyl group and a pentadecyl group; a cycloalkyl group such as a cyclopentyl group, a cyclohexyl group; an alkenyl group such as a vinyl group and an allyl group; an alkynyl group such as an ethynyl group and a propalgyl group; an aryl group such as a phenyl group, a p-chlorophenyl group, a mesityl group, a tolyl group, a xylyl group, a naphthyl group, an anthoryl group, an azurenyl group, an acenaphthenyl group, a fluorenyl group, a phenathoryl group, an indenyl group, a pyrenyl group and a biphenyl group; an aromatic heterocyclic group such as a furyl group, a thienyl group, a pyridyl group, a pyridazyl group, pyrimidyl group, a triazyl group, an imidazolyl group, a pyrazolyl group, a thiazolyl group, a benzimidazolyl group, a benzoxazolyl group, a quinazolyl group and a phtharadyl group; a heterocyclic group such as a pyrrolidyl group, an imidazolidyl group, a morpholyl group and a oxazolidyl group; an alkoxyl group such as a methoxy group, an ethoxy group, a propyloxy group, a pentyloxy group, a hexyloxy group and an octyloxy group; a cycloalkoxy group such as a cyclopentyloxy group and a cyclohexyloxy group; an aryloxy group such as a phenoxy group and a naphthyloxy group; an alkylthio group such as a methylthio group, an ethylthio group, a propylthio group, a pentylthio group, a hexylthio group, an octylthio group and a dodecylthio group; a cycloaalkylthio group such as a cyclopentylthio group and a cyclohexylthio group; an arylthio group such as a phenylthio group and a nephthylthio group; an alkoxycarbonyl group such as a methyloxycarbonyl group, an ethyloxycarbonyl group, a butyloxylcarbonyl group, an octyloxycarbonyl group and a dodecyloxycarbonyl group; an aryloxycarbonyl group such as a phenyloxycarbonyl group and a naphthyloxycarbonyl group; a sulfamoyl group such as an aminosulfonyl group, a methylaminosulfonyl group, a dimethylaminosulfonyl group, a butylaminosulfonyl group, a hexylaminosulfonyl group, a cyclohexylaminosulfonyl group, an octylaminosulfonyl group, a dodecylaminosulfonyl group, a phenylaminosulfonyl group, a naphthylaminosulfonyl group and a 2-pyridylaminosulfonyl group; an acyl group such as an acetyl group, an ethylcarbonyl group, a propylcarbonyl group, a pentylcarbonyl group, a cyclohexylcarbonyl group, a naphthylcarbonyl group and a pyridylcarbonyl group; an acyloxy group such as an acetyloxy group, an ethylcarbonyloxy group, a butylcarbonyloxy group, an octylcarbonyloxy group, a docecylcarbonyloxy group and a phenylcarbonyloxy group; an amido group such as a methylcarbonylamino group, an ethylcarbonylamino group, a dimethylcarbonylamino group, a propylcarbonylamino group, a pentylcarbonylamino group, a cyclohexylcarbonylamino group, a 2-ethylhexylcarbonylamino group, an octylcarbonylamino group, a dodecylcarbonylamino group, a phenylcarbonylamino group and a naphthylacarbonylamino group; a carbamoyl group such as an aminocarbonyl group, a methylaminocarbonyl group, a dimethylaminocarbonyl group, a propylaminocarbonyl group, a pentylaminocarbonyl group, a cyclohexylaminocarbonyl group, an octylaminocarbonyl group, a 2-ethylhexylaminocarbonyl group, a dodectlaminoocarbonyl group, a phenylaminocarbonyl group, a naphthylaminocarbonyl group and a 2-pyridylaminocarbonyl group; a ureido group such as a methylureido group, an ethylureido group, a pentylureido group, a cyclohexylureido group, an octylureido group, a dodecylureido group, a phenylureido group, a naphthylureido group and a 2-pyridylureido group; a sulfinyl group such as a methylsulfinyl group, an ethylsulfinyl group, a butylsulfinyl group, a cyclohexylsulfinyl group, a 2-ethylhexylsulfinyl group, a dodecylsulfinyl group and a phenylsulfinyl group; an alkylsulfonyl group such as a methylsulfonyl group, an ethylsulfonyl group, a butylsulfonyl group, a cyclohexylsulfonyl group, a 2-ethylhexylsulfonyl group and a dodecylsulfonyl group; an arylsulfonyl group such as a phenylsulfonyl group, a naphthylsulfonyl group and a 2-pyridylsulfonyl group; an amino group such as an amino group, an ethylamino group, a dimethyamino group, a butylamino group, a cyclopentylamino group, a 2-ethylhexylamino group, a dodecylamino group, an anilino group, a naphthylamino group and a 2-pyridylamino group; a halogen atom such as a fluorine atom, a chlorine atom and a bromine atom; a fluorohydrocarbon group such as a fluoromethyl group, a trifluoromethyl group, a pentafluoroethyl group and a pentafluorophenyl group; a cyano group; and a silyl group such as a trimethylsilyl group, triisopropylsilyl group, a triphenylsilyl group and a phenyldiethylsilyl group.

These substituents each may be further substituted by the above substituents and plural of them may form a ring by bonding with each other.

Among them, the alkyl groups are most preferable and the alkyl groups having 2 to 20 carbon atoms are more preferable, and those having 6 to 12 carbon atoms are most preferable.

### «Terminal group of thiophene oligomer»

The terminal group of the thiophene oligomer preferably employed in the invention is described below.

The terminal group of the thiophene polymer to be employed in the invention is preferably one having no thienyl group; and examples of preferable terminal group include an aryl group such as a phenyl group, a p-chlorophenyl group, a mesityl group, a tolyl group, a xylyl group, a naphthyl group, an anthoryl group, an azulenyl group, an acenaphthenyl group, a fluorenyl group, a phnanthryl group, an indenyl group, a pyrenyl group and a biphenylyl group; an alkyl group such as a methyl group, an ethyl group, a propyl group, an isopropyl group, a tert-butyl group, a pentyl group, a hexyl group, an octyl group, a dodecyl group, a tetradecyl group and a pentadecyl group; and a halogen atom such as a fluorine atom, a chlorine atom and a bromine atom.

### «Steric structural property of repeating unit of thiophene oligomer»

The thiophene oligomer to be used in the invention is preferably one having no Head-to-Head structure, and ones having a Head-to-Tail structure or a Tail-to-Tail structure are preferable.

About the Head-to-Head, Head-to-Tail and Tail-to-Tail Structures relating to the invention, "Π-electron System Organic Solid", edited by the Chemical Society of Japan, Publication Center of the Chemical Society of Japan, p.p. 27 to 32, 1998, and Adv. Mater. 1998, 10, No. 2, P.P. 93 - 116, can be referred. The structural characteristics of them are described below in concrete.

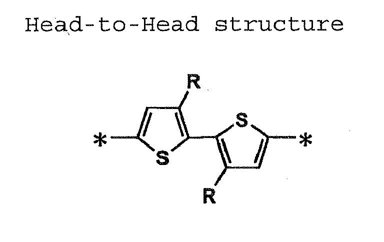

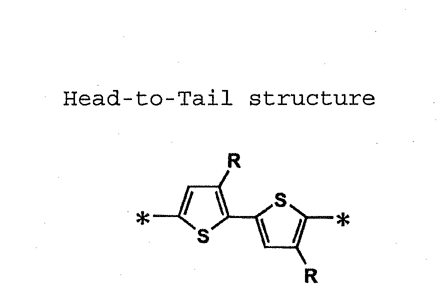

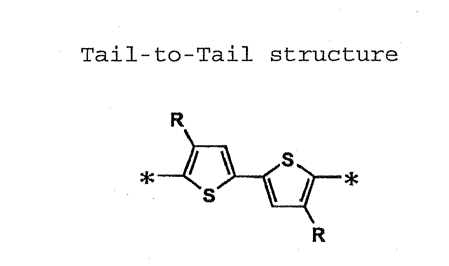

In the above formulas, R is synonym for that in Formula 1.

The concrete examples of the thiophene oligomer are listed below, but the invention is not limited to them.

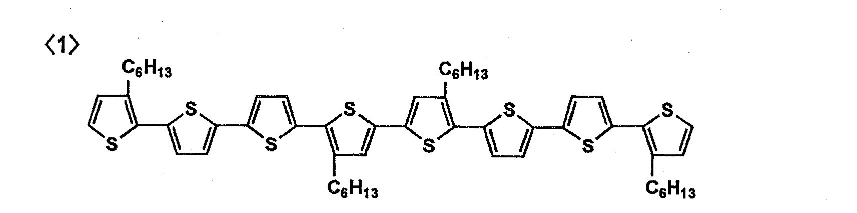

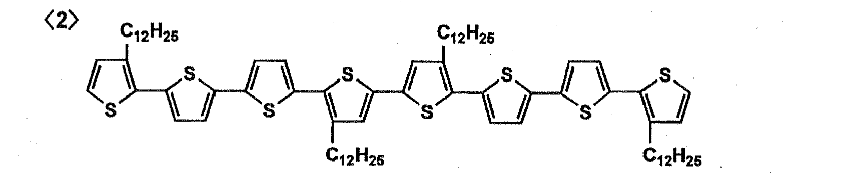

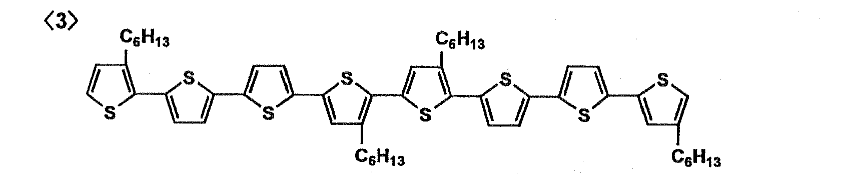

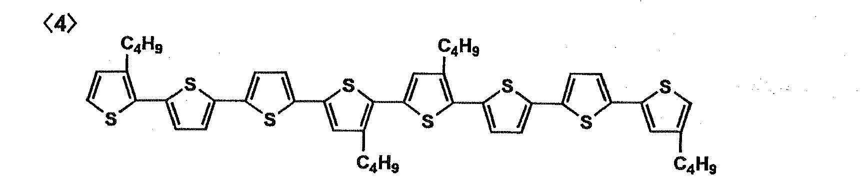

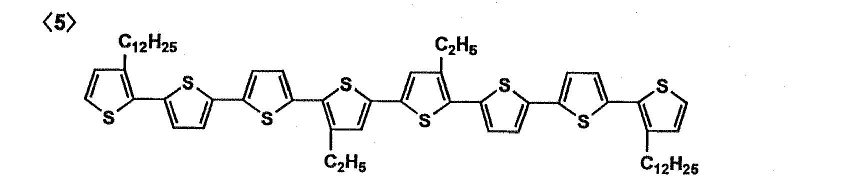

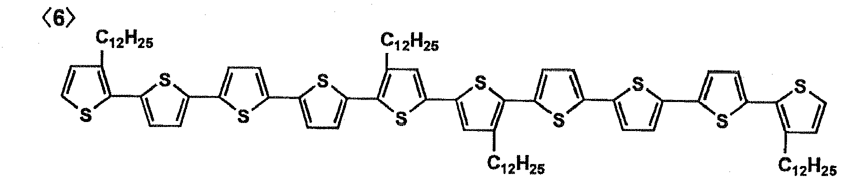

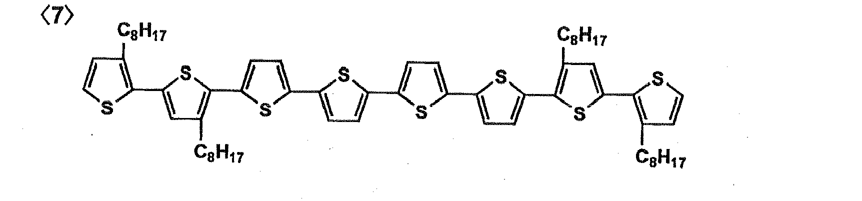

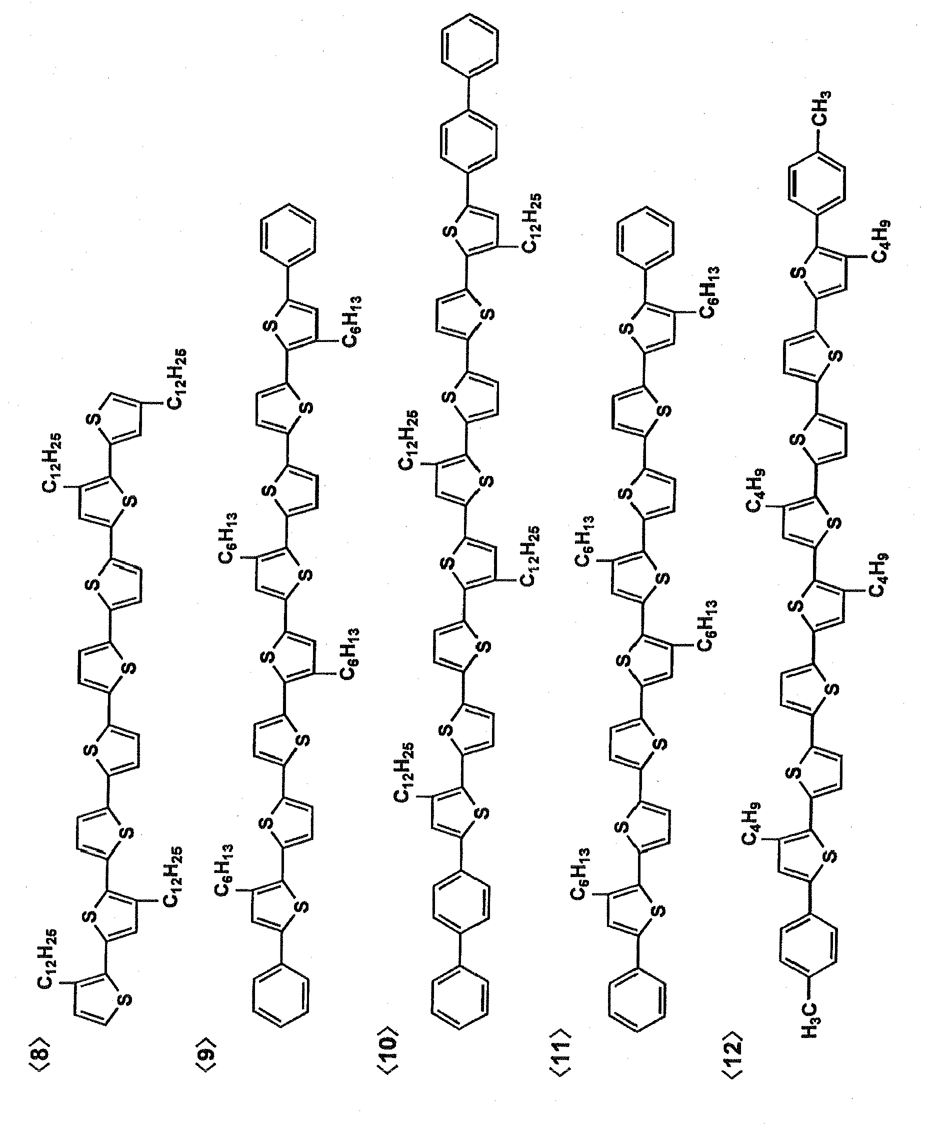

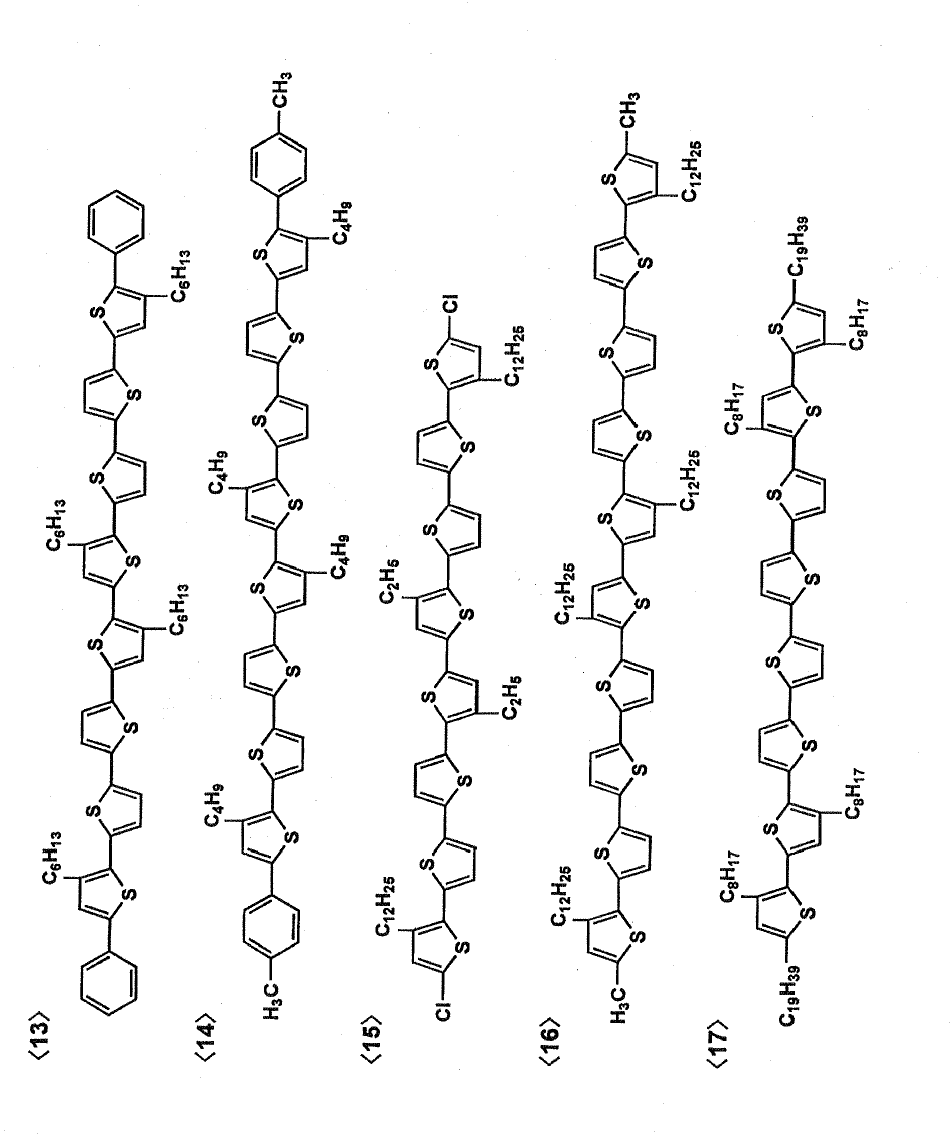

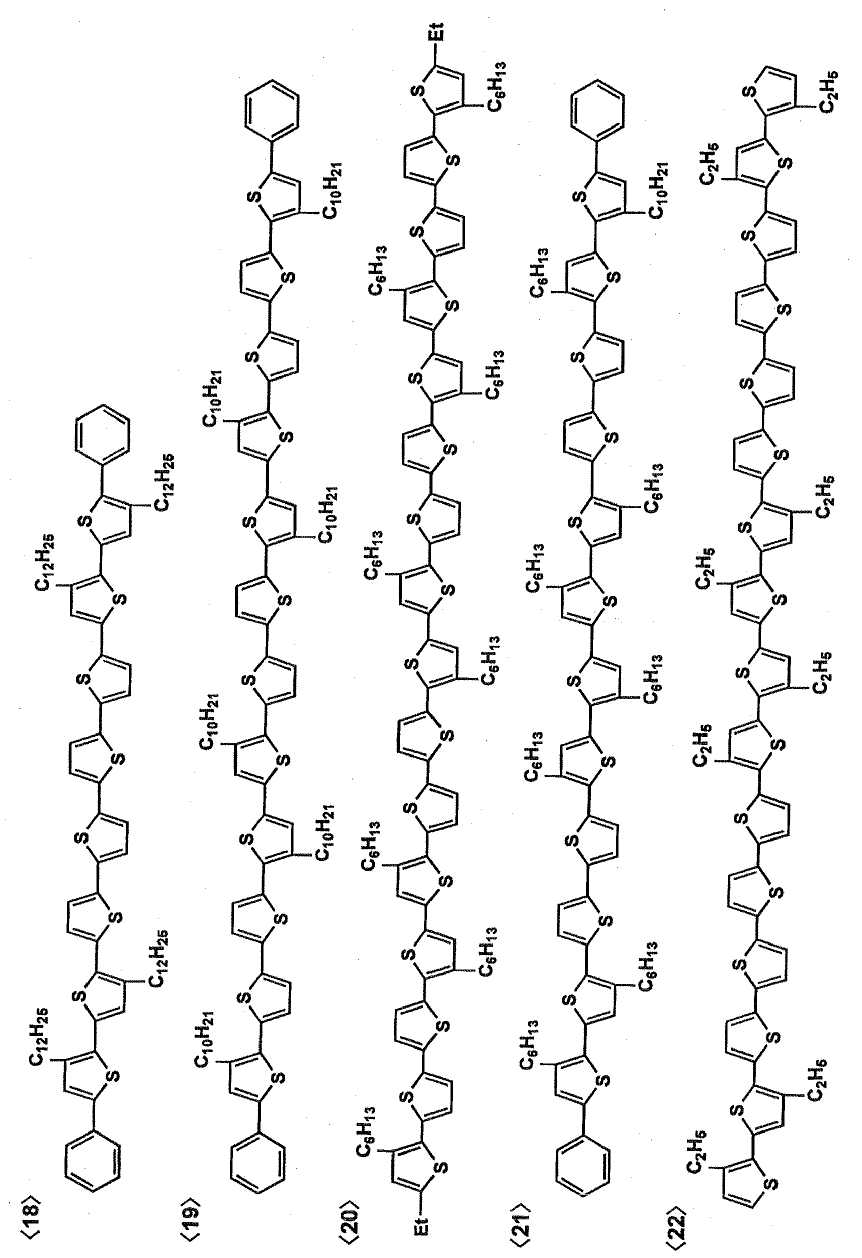

In the invention, these semiconductive materials are once dissolved in a solvent, and the resultant solution is supplied (or patterning when it is necessary) onto a certain area of the substrate by coating, ink-jetting or printing and then dried, then a part of the surface (it may be not necessarily the surface, but the physical and mechanical treatment is easily given to the surface) of thus formed layer is subjected to a heating treatment after a pretreatment.

The pretreatment is basically to apply mechanical stress such as scratching and rubbing to apart of the organic semiconductor layer formed by drying, by which the crystallization or orientation at the surface of the material is initiated. The acceleration and strengthening of the orientation or the crystallization of the organic semiconductive material is accelerated at such the part by the heating treatment following the pretreatment. The applied stress acts as the trigger for accelerating the crystallization. As the treating method includes bending treatment additionally to the scratching and the rubbing; and the stress applying by the mechanical treatment is preferred. The pretreatment may contain a thermal or chemical action such as laser light irradiation, contacting with a solvent, dropping of a fine droplet and injection by an ink-jet other than the mechanical treatment. Other than the above, any treatments capable of accelerating the orientation are included in the pretreatment according to the invention.

In the practical treatment, however, the pretreatment by mechanically means such as the scratching and rubbing is preferable, and it is particularly preferable to form a scratched area at a part of the thin film of the organic semiconductive material. After the formation of the semiconductor layer, a part of the layer, where the thin film transistor to be constituted, is given a small scratch by a needle, for example, after that the layer is subjected to the heating treatment for a certain time within the range of from 10 seconds to 1 week at a temperature of from 50 °C to 250 °C. By such the treatment, the orientation or the crystallization is accelerated.

The heating treatment to be applied after the pretreatment is preferably carried out at the exothermic point of the organic semiconductive material, and the treatment is performed at the exothermic point within the range of from 50 °C to 250 °C for a time of from 10 seconds to 1 week though the treatment condition is varied according to the kind of the organic semiconductor to be employed.

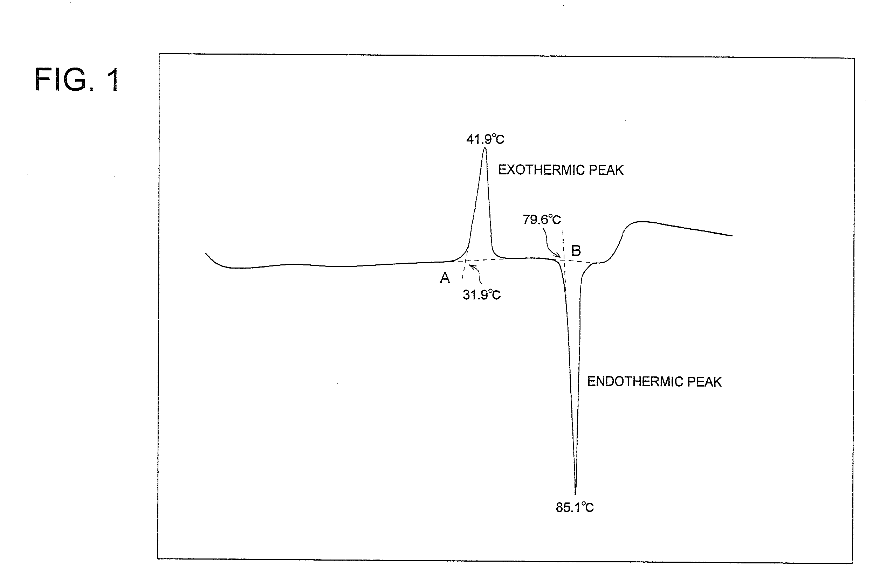

The organic semiconductive material such as the low molecular weight compound or the thiophene oligomer shows the exothermic point (exothermic peak) and the endothermic point (endothermic peak) in the differential scanning calorimetric (DSC) measurement. An example of the thiophene oligomer, Compound 1, is shown in Fig. 1. In the example, the measurement was carried out at a temperature rising rate of 10 °C/minute by using a differential scanning calorimetric analyzer DSC 6220, manufactured by SSI Nanotechnology Co., Ltd.

Though the measured data are varied a little according to the temperature rising condition, stabile results can be obtained by relatively slow temperature rising condition. In the invention, the exothermic point and the endothermic point can be defined as those measured at the temperature rising rate of 10 °C/minute.

In Fig. 1, the endothermic peak correspondents to heat releasing from the semiconductive material, it is supposed that the material release heat as a result of transfer of the state of the molecule itself or interaction of the molecules. Generally, the exothermic point is considered as a temperature at which the crystallization, variation in the crystal structure or any variation in the structure is caused.

The endothermic peak is a temperature corresponding to a process of thermal disintegration process of a structured orientation such as melting of the crystal, and heat of fusion is required.

In the DSC measurement, the exothermic point A is defined by the heat releasing initiation temperature at the crossing point of the strait line portion of the rising up line of the exothermic peak and the base line, cf. Fig. 1. Therefore, in the rising up curve, the point is a cross point of a normal line at the flexion point and the base line.

The endothermic point B is defined by the temperature corresponding to the crossing point of the straight portion of the falling line from the base line in the heating course and the base line (heat adsorption initializing temperature), cf. Fig. 1.

In the case of the foregoing thiophene oligomer, the exothermic point and the endothermic point are 31.9 °C and 79.6 °C, respectively, cf. Fig. 1.

Therefore, the heat treatment at the exothermic point according to the invention is a heating treatment at a temperature within the range of from the endothermic point and the exothermic point measured by the differential scanning calorimetric measurement (DSC). The crystallization of the material, variation in the crystal structure or any structural formation such as increasing of the π-stacks tends to be caused by heating treatment in such the temperature range.

In the case of the foregoing thiophene oligomer, the semiconductor layer is formed by dissolving the oligomer in a solvent such as chloroform, coating on the substrate and drying the coated layer. There is possibility in the organic semiconductor thin film that the orientation of the molecules can be accelerated, strengthened and structured regularly in some degree at the π-stack forming portion by the heating treatment for a certain times at a temperature of not less than the exothermic point and not more than endothermic point, even if the thin film is once formed as one having amorphous structure in which the molecules are randomly oriented. However, such the process is a solid state process and slowly progressed. It is supposed, therefore, that the pretreatment such as the scratching according to the invention displays the effect of considerably accelerating the orientation and structuring of the semiconductive material by the heating treatment. The considerable acceleration of the crystallization or the structuring of the molecule orientation can be attained by the heating treatment at the exothermic point after the pretreatment on a part of the organic semiconductor thin film formed by the coating; such the results are difficultly attained for a short duration only by the coating or the heating treatment after the coating.

Furthermore, the increasing in the size or the number of the crystallized area in the organic semiconductor thin film can be attained by the above treatments. It is supposed that the semiconductor layer having high carrier mobility can be formed and the FET characteristics of the organic thin film transistor using such the semiconductor thin film can be improved.

The formation method of the semiconductor thin film is not limited to the coating method, and various methods such as an ink-jet method and a printing method can be applied.

The exothermic point of the organic semiconductive material is preferably within the range of from 50 °C to 200 °C since the heating treatment can be performed by a usual heating means such as electric heater at a temperature of from 50 °C to 200 °C for certain duration.

Among the organic semiconductive material, any compounds having such the exothermic point (exothermic peak) and the endothermic point (endothermic perk) measured by the differential scanning calorimetric analysis can be applied in the present invention. The method according to the invention is usefully applied when the semiconductor layer is obtained by dissolving and coating the pentathene or a derivative thereof.

As above-mentioned, the weight average molecular weight of the organic semiconductive material to be used is preferably not more than 5,000 for crystallizing or strengthening the orientation by the pretreatment and the heating treatment according to the invention. When the molecular weight is excessively high, the effect of accelerating the crystallization is lowered and the effect of the heating treatment itself is also made small.

In the invention, it is preferable to employ the alkylthiophene oligomer having a weight average molecular weight of not more than 5,000 for obtaining the structured thin film of the organic semiconductive material strengthened and accelerated in the orientation.

The heating treatment temperature may be varied or held at a constant value within the range of from the exothermic point to the endothermic point, and a temperature suitable for the crystallization or the strengthening the orientation may be searched and applied for each of the compounds.

Though the organic semiconductive material is dissolved in the solvent and the solution is coated on the substrate to form the organic semiconductor thin film according to the invention, the material is not necessarily dissolved completely and may be made into dispersion as long as a uniform layer can be formed. By forming the layer uniform in the thickness thereof, the reorientation of the molecules and the fusion between the areas of composed of fine crystals are caused by the pretreatment and the heating treatment after the layer formation to increase the structured area and the number of the structured area so that the organic semiconductor layer having the high carrier mobility can be obtained.

In the invention, a solvent having sufficient dissolving ability to the organic semiconductive material is preferably employed for dissolving the organic semiconductive material and forming the layer thereof. The solvent is preferably ones capable of easily dissolving the organic semiconductive material at room temperature of by heating.

The values such as the solubility are actually varied considerably depending on the semiconductive material and the combination of the solvents, and the purity and the orientation of in the formed organic semiconductor layer are varied. Therefore, it is preferable that the combination of the solvents is investigated by experimental tests. The dissolving degree can be controlled by mixing of the solvents.

The dissolving temperature is usually selected within the range of from 50 °C to 200 °C, though the temperature is varied depending on the kind of the organic semiconductive material and the solvent to be employed. The solution is preferably coated on the substrate at a temperature at which sufficient dissolving ability is maintained.

For the solvent, ones having a boiling point within the range of from 50 °C to 200 °C are preferably employed from the viewpoint of drying and handling.

The π-stacks are effectively formed in the organic semiconductive material formed by deposition on the substrate by recrystallizing phenomenon by the evaporation of the solvent so that the layer has preferable characteristics as the organic semiconductor thin film.

Various coating methods such as a spray coating method, a spin coating method, a blade coating method, a dipping coating method, a casting coating method, a roller coating method a bar coating method and a die coating method, can be applied The method for supplying the solution containing the organic semiconductive material onto the substrate for forming the organic semiconductor thin film. The coating liquid employed for forming the organic semiconductor layer is a liquid in which the organic semiconductive material according to the invention is dissolved or dispersed in the organic solvent. The organic solvent to be used is suitably selected according to the organic semiconductive compound from wide range of solvent such as a hydrocarbon type, an alcohol type, an ether type, a ketone type and a glycol ether type, and chain-shaped ether type solvents such as diethyl ether and diisopropyl ether, cyclic ether type solvents such as tetrahydrofuran and dioxane, ketone type solvents such as acetone and methyl ethyl ketone, aromatic type solvents such as cyclohexanone, xylene, toluene, o-dichlorobenzene, nitrobenzene and m-cresol, hexane, tridecane, α-terpionel, alkyl halide type solvents such as chloroform and 1,2-dichlorohexane, and N-methylpyrrolidone and carbon disulfide.

The layer can be formed by flying the dispersion by the ink-jet method. By such the method, an active semiconductor layer 1 can be formed with high efficiency and low energy loss in a shape of narrow gutter between a source electrode 2 and a drain electrode 3 shown in Fig, 3.

The organic semiconductor thin film according to the invention is formed by supplying and drying the designated amount of the organic semiconductive material solution by the above-described method, or by a method corresponding to patterning when the patterning is necessary. The surface of thus formed semiconductor layer is subjected to the pretreatment and to the heating treatment to form the organic semiconductor thin film according to the invention is formed.

The thickness of thus formed organic semiconductor layer is preferably within the range of from 5 nm to 1 µm, and more preferably from 10 nm to 100 nm.

In the invention, the organic semiconductor layer is preferably formed on the gate and the gate isolating layer in usual. The organic semiconductor layer is preferably formed on a hydrophobic surface having high contact angle to water such as the gate isolating layer. In the invention, the substrate having the surface having a contact angle of not less than 60°, further not less than 80°, is preferably, on which the uniform organic semiconductor layer with no defect can be formed. In the case of the bottom gate type thin film transistor, it is preferable embodiment of the invention that the gate electrode and the gate isolating layer are provided on the substrate and then the organic semiconductor thin film is formed on the gate isolating layer.

### «Organic thin film transistor, electric field effect transistor and switching element»

The organic thin film transistor according to the invention is described below. The organic thin film transistor according to the invention is called as a switching element, an organic TFT element or an electric field effect transistor according to the employing situation.

The organic TFT material according to the invention can provide a suitably drivable switching element, which can be also referred to as transistor device, when it is employed as the channel layer of the organic TFT or the electric field effect transistor. The organic TFT (organic thin film transistor) can be roughly classified into a top-gate type in which the source electrode and the drain electrode connected by an organic semiconductor channel are provided on the substrate and the gate electrode is provided through the gate isolating layer on them , and a bottom-gate type in which the gate electrode is provided on the substrate and the source electrode and the drain electrode connected by the organic semiconductor channel are arranged on the gate electrode through the gate isolating layer.

For providing the organic semiconductive material according to the invention as the channel, which can be also referred to as the channel layer, the solution of the material prepared by dissolving the material in the suitable solvent and adding an additive according to necessity is supplied on the substrate in a thin film state by the coating method such as the cast coating method, spin coat method, printing method, ink-jet method and abrasion method, and dried and the thus formed thin film is subjected tot the pretreatment and the heating treatment.

In the invention, the material for forming the source electrode, drain electrode and gate electrode is not specifically limited, and various metals such as platinum, gold, silver, nickel, chromium, copper, iron, tin, antimony, lead, tantalum, indium, palladium, tellurium, rhenium, iridium, aluminum, ruthenium, germanium, molybdenum, tungsten, tin·antimony oxide, indium·tin oxide (ITO), fluorine-doped zinc oxide, zinc, carbon, graphite, glassy carbon, silver past, carbon past, lithium, beryllium, sodium, magnesium, potassium, calcium, scandium, titanium, manganese, zirconium, gallium, niobium, sodium-potassium alloy, magnesium-copper mixture, magnesium-indium mixture, aluminum-aluminum oxide mixture and lithium-aluminum mixture can be employed, and platinum, gold, silver copper, aluminum, indium, ITO and carbon are particularly preferable.

Methods for forming the electrode include a method in which an electroconductive thin film formed by a vapor depositing or spattering is formed to the electrode by known photolithographic method or lift-off method, and a method in which a resist is formed on a metal foil such as aluminum and copper by thermal a transfer or ink-jet method and then the foil is etched.

Moreover, for forming the electrode, a method for patterning an electroconductive fine particle dispersion or a dispersion or solution of an electroconductive polymer is directly patterned by ink-jet, and that in which the electrode is formed from the coated layer by a lithographic method or a laser ablation method are applicable. Furthermore, a method in which an electroconductive polymer or a ink containing electroconductive fine particles or an electroconductive past is patterned by a printing method such as a relief printing, an intaglio printing, a lithographic printing and a screen printing is applicable.

Known electroconductive polymers increased in the dielectric constant by doping such as electroconductive polyaniline, electroconductive polypyrrol, electroconductive polythiophnen and a complex of polyethylenedioxythiophene and polystyrenesulfonic acid are suitably employed. Among then ones having low electric resistivity at the contacting face with the semiconductor layer are preferable.

For example, the electrode can be formed by the following procedure; electroconductive fine particles of metal are dispersed in a dispersing medium such as water or a mixture of water and an organic solvent preferably using an organic dispersion stabilizer to prepare an electroconductive fine particle dispersion such as a past or an ink, and the dispersion is coated and patterned to for the electrode.

Platinum, gold, silver, cobalt, nickel, chromium, copper, iron, tin, antimony, lead, tantalum, indium, palladium, tellurium, rhenium, iridium, aluminum, ruthenium, germanium, molybdenum, tungsten and zinc are employable for the metal material (metal powder) of the electroconductive fine particle. Among them, platinum, gold, copper, cobalt, chromium, iridium, nickel, palladium, molybdenum and tungsten each having a work function of not less than 4.5 eV are particularly preferred.

For the method for producing such the metal fine particle dispersion, a physical producing method such as a method of vaporizing in gas phase, a spattering method and a metal vapor synthesizing method, and a chemical producing method in which metal ions are reduced in a liquid phase are applicable, and the metal fine particle dispersion produced by a colloid method described in Tokkai Hei 11-76800, 11-80647, 11-319538, Tokkai 2000-239853 and that produced by the method of vaporizing in gas described in Tokkai 2001-254185, 2001-53028, 2001-35255, 2000-124157 and 2000-123634 are preferable.

The average particle diameter of the dispersed metal fine particles is not more than 20 nm is preferable for enhancing the effects of the invention.

The metal fine particle dispersion preferably contains the electroconductive polymer. The ohmic contact of the electrode with the semiconductor layer can be formed by the electroconductive polymer when the source electrode and drain electrode are formed by patterning and pressing and heating the metal fine particle dispersion containing the electroconductive polymer. Namely, the effects of the invention can be further enhanced by the presence of the electroconductive polymer on the metal fine particle surface to reduce the contacting resistance with the semiconductor and by fusing the metal fine particles by heating.

As the electroconductive polymer, known electroconductive polymers increased in the dielectric constant by doping such as electroconductive polyaniline, electroconductive polypyrrol, electroconductive polythiophnen and a complex of polyethylenedioxythiophene and polystyrenesulfonic acid are suitably employed.

The content of the metal fine particles in the electroconductive polymer is preferably from 0.00001 to 0.1 in weight ratio. When the content exceeds the above range, the fusion of the metal fine particles can be disturbed.

The electrode is patterned by the metal fine particle dispersion and the metal fine particles are fused with together by heating to form the source or drain electrode. It is preferable to accelerate the fusion by applying a pressure of approximately from 1 to 50,000 Pa, preferably from 1,000 to 10,000 Pa, on the occasion of the formation of the electrode.

For patterning the shape of electrode using the metal fine particle dispersion, for example, a method can be applied in which the metal fine particle dispersion is employed as an ink and patterned by a printing method. Furthermore, there is a method for patterning by an ink-jet method in which the metal fine particle dispersion is jetted out from an ink-jet head to making pattern of the electrode by the metal fine particle dispersion. As the method for jetting out from the ink-jet head to make the pattern, known methods, for example, an on-demand system such as a piezo method and Bubble-Jet® method and an electrostatic suction system such as a continuous jetting out method can be applied.

For the heating and the pressing, known methods such as that used in a heating laminator can be employed.

In the invention, the organic semiconductor thin film may be subjected to doping treatment on the occasion of the formation thereof by adding, for example, a material having a functional group such as acrylic acid group, acetoamido group, a dimethylamino group, a cyano group, a carboxyl group and a nitro group; a material acting as acceptor capable of accepting an electron, a material having a functional group such as an amino group, a triphenyl group, an alkyl group, a hydroxyl group, an alkoxy group or a phenyl group, a material acting as a donor capable of donating an electron, for example, a substituted amine such as phenylenediamine, anthracene, benzoanthracene, a substituted benzoanthracene, pyrene, a substituted pyrene, carbazole and its derivative, and tetrathiafluvalene and its derivative.

The doping treatment is applied to introducing an electron accepting molecule (acceptor) or an electron donating molecule (donor) into the thin film. Consequently, the doped thin film is a thin film containing the condensed polycyclic aromatic compound and the dopant. In the invention, the acceptor and the donor can be both employed; and known materials and processes can be applied for the doping treatment.

Various isolative layers can be employed for the gate isolation layer, and an inorganic oxide layer having high specific dielectric constant is preferable. As the inorganic oxide, silicone oxide, aluminum oxide, tantalum oxide, titanium oxide, tin oxide, vanadium oxide, barium strontium titanate, barium zirconate titanate, lead zirconate titanate, lead lanthanum titanate, strontium titanate, barium titanate, barium magnesium fluoride, bismuth titanate, strontium bismuth titanate, strontium bismuth tantalate, bismuth tantalate niobate and yttrium trioxide can be cited. Among them, silicone oxide, aluminum oxide, tantalum oxide and titanium oxide are preferable. An inorganic nitride such as silicone nitride and aluminum nitride is also suitably employable.

For forming the layer, dry processes such as a vacuum vapor deposition method, a molecular ray epitaxial growing method, an ion cluster beam method, a low energy ion beam method, an ion plating method, a CVD method, a spattering method and an atmosphere pressure plasma method, and wet processes including methods by coating such as a spray coating method, a spin coating method, a blade coating method, a dipping coating method, a casting method, a roller coating method, a bar coating method and a die coating method, and patterning by printing and that by ink-jetting are applicable corresponding to the material.

In the wet process, a method in which fine particles of the inorganic oxide is dispersed by an optional organic solvent or water, further a dispersion aid such as a surfactant is employed according to necessity, and the dispersion is coated and dried or a method so called as a sol-gel method is applied in which a solution of a precursor of the oxide such as an alkoxide compound is coated and dried. Among them, the atmosphere plasma method and the sol-gel method are preferred.

The isolation layer forming method by the plasma treatment under the atmosphere pressure is a method in which a reactive gas is excited to a state of plasma by electric discharge under atmosphere of near atmosphere pressure so as to form the thin film on the substrate. Such the method is described in Tokkai Hei 11-61406 and 11-133205, and Tokkai 200-121804, 2000-147209 and 2000-185362, hereinafter the method is referred to as the atmosphere pressure plasma method. The highly functional thin film can be produced with high productivity by this method.

For the organic compound layer, polyimide, polyamide, polyester, polyacrylate, a photo-hardenable resin such as a photo-radical polymerized polymer and a photo-polymerized cation polymer, a copolymer containing an acrylonitrile component, polyvinylphenol, poly(vinyl alcohol), a novolac resin and cyanoethylpullulan can be employed. The wet process is preferable for forming the organic compound layer. The inorganic layer and the organic layer may be employed together with in a laminated state. The thickness of the isolation layer is usually from 50 nm to 3 µm, and preferably from 100 nm to 1 µm.

An optional orientation treatment may be applied between the gate isolating layer and the organic semiconductor layer. A self constituting orientation layer such as that of a silane coupling agent, for example, octadecyltrichlorosilane, trichloromethylsilazane, an alkanephosphoric acid, an alkanesulfonic acid and an alkanecarboxylic acid is suitably employed. The surface of the gate isolating layer formed by such the orientating treatment is a hydrophobic layer having a contact angle to water of not less than 60°, and preferably not less than 80°. On the substrate having such the gate isolating layer, the organic semiconductor layer of the invention is formed and then the source electrode and the drain electrode are provided to obtain the organic thin film transistor according to the invention.

In the invention, the substrate on which the gate, the organic semiconductor layer, the source electrode and the drain electrode are arranged is formed by glass or flexible resin sheet, and a plastic film can be employed as the sheet, for example. Examples of the plastic film include a film of poly(ethylene terephthalate) (PET), poly(ethylene naphthalate) (PEN), polyethersulfone (PES), polyetherimide, poly(ether ether ketone), poly(phenylene sulfide), polyallylate, polyimide, polycarbonate (PC), cellulose triacetate (TAC) and cellulose acetate propionate (CAP). By the use of the plastic film, lower weight, higher portability and the higher resistivity against shock can be obtained compared with the use of the glass.

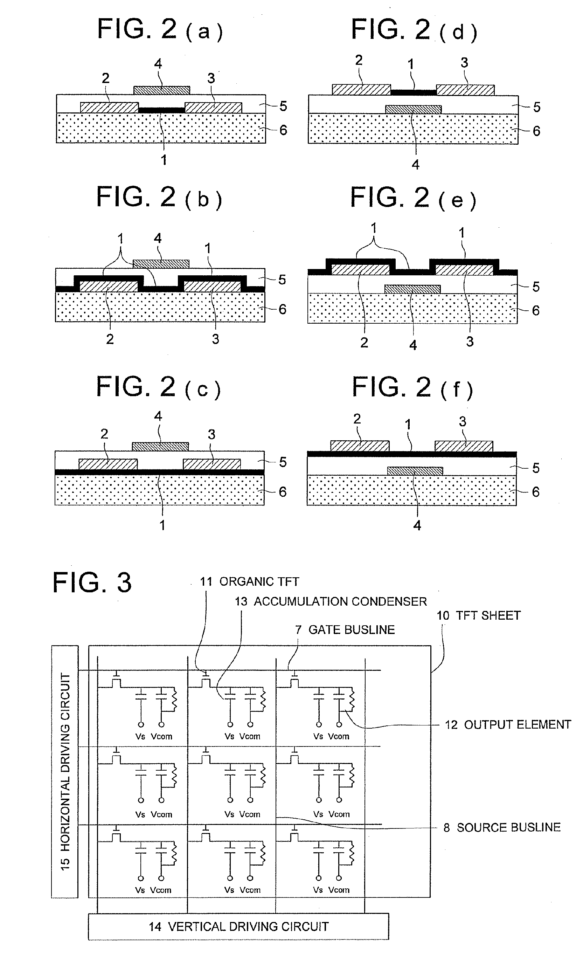

An example of constitution of the organic thin film transistor according to the invention is shown in Fig. 2.

Fig. 2(b) shows an organic TFT produced by the following procedure; a pattern is formed on a glass substrate 6 by vapor deposition of gold using a mask, and a pattern of a layer containing the metal fine particles is formed, after that the metal fine particles-containing layer may be heated and pressed to be fused to form the source electrode 2 and the drain electrode 3, then the organic semiconductor layer 1 the gate isolating layer 5 are formed on them, further the gate electrode 4 is provided on the organic semiconductor layer.

Figs. 2(a) and 2(c) show other constitution examples of top gate type organic thin film transistor.

Fig. 2(f) shows a bottom gate type organic TFT which is produced by the following procedure; the gate electrode 4 is formed on the substrate 6, and then the gate isolating layer 5 is formed on that, after that, the organic semiconductor layer is formed on that and the source electrode 2 and the drain electrode 3 are provided. The other constitution examples are shown in Figs. 2(d) and 2(e).

Fig. 3 shows a schematic equivalent circuit drawing of a TFT sheet constituted by using the foregoing organic thin film transistor for outputting device such as a liquid crystal or an electrophoresis element.

The TFT sheet 10 has many organic TFTs 11 arranged in matrix. In the drawing, 7 is a gate busline and 8 is a source busline of each of the organic TFTs. An output element 12 such as the liquid crystal or the electrophoresis element is connected for constituting the pixel in the displaying apparatus. The pixel electrode may be applied as an input electrode of a photo-sensor. In the example shown in the drawing, a liquid crystal as the output element is illustrated by an equivalent circuit drawing composed of a resistor and a condenser. In the drawing, 13 is an accumulation condenser, 14 is a vertical driving circuit and 15 is a horizontal driving circuit.

### EXAMPLE

The invention is described referring examples below; the invention is not limited to the examples.

On a Silicon wafer having an oxide layer by heating and treated by octadecyltrichlorosilane (OTS), 6.0 weight-% solution of thiophene polymer, Exemplified Compound 9, in a mixed solvent of cyclohexane/THF in a volume ratio of 90/10 was coated by spin coating and dried to form an organic semiconductor layer having a thickness of 20 nm on the substrate. After that, scratches were formed on the organic semiconductor layer by a stainless steel needle. The layer was subjected to a heat treatment by standing for 15 minutes at 93 °C for 15 according to a result of differential scanning calorimetric analysis (DSC) of the thiophene oligomer. A crystal having a size of about 100 µm was grown from the scratched portion. Gold was vapor deposited onto this portion and the source and drain electrodes were formed to prepare an organic thin film transistor.

The exothermic point and the endothermic point of the thiophene oligomer, Exemplified Compound 9, were 59.2 °C and 102.7 °C, respectively, according to measurement by a differential scanning calorimetric analyzer DSC 6220, manufactured by SSI Nanotechnology Co., Ltd.

Another organic thin film transistor was prepared in the same manner as in the above transistor. The FET characteristics of the above two transistor were evaluated by measuring the carrier mobility, the threshold of gate voltage and the fluctuation of these values by repeating of the measurements.

### <<Evaluation of carrier mobility>>

The carrier mobility in cm²/V·s of each of the above-obtained transistors was determined from the saturated area of I-V characteristics.

### <<Threshold value>>

The threshold value of the gate voltage was determined from the variation of the drain current depending on the increasing of the gate voltage of from 0 to 30V.

The measurement of the carrier mobility and the threshold value of the gate voltage were repeated and the occurrence of the fluctuation in the measured values was evaluated.

| | Scratched | Non-scratched |
|---|---|---|
| Mobility | 0.3 | 0.1 |
| Repeating stability | Without fluctuation | With fluctuation |
| Threshold voltage | 10 V | 25 V |

The thin film transistor having the organic semiconductor layer scratched according to the invention was superior in the high carrier mobility, low threshold voltage and no occurrence of fluctuation of the characteristics.

### Example 2

A transistor was prepared in the same manner as in that in Example 1 except that the scratching process was replaced by dropping 10 pl of toluene drops to the semiconductor layer. A crystal similar to that in Example 1 was grown from the portion where the drop of toluene was dropped.

The characteristics of thus obtained transistor were evaluated in the same manner as in Example 1 and similar results regarding the carrier mobility, repeating property and threshold voltage were obtained.

## Claims

1. A method for forming an organic semiconductor layer comprising the steps of
applying a pretreatment to a part of an organic semiconductor layer formed on a substrate, and
applying a heat treatment to the organic semiconductor layer after the pretreatment.

2. The method for forming the organic semiconductor layer of claim 1, wherein the pretreatment is performed by a mechanical action.

3. The method for forming the organic semiconductor layer of claim 2, wherein a scratched portion is formed at a part of the organic semiconductor layer.

4. The method for forming the organic semiconductor layer according to any of claims 1 to 3, wherein the heating treatment is performed at a temperature higher than the exothermic point of the organic semiconductive material contained in the organic semiconductor layer measured by differential scanning caloiimelric analysis.

5. The method for forming the organic semiconductor layer according to any of claims 1 to 4, wherein the molecular orientation of the organic semiconductive material contained in the organic semiconductor layer is accelerated by the heating treatment.

6. The method for forming the organic semiconductor layer according to any of claims 1 to 5, wherein the exothermic point of the organic semiconductive material measured by the differential scanning calorimetric analysis is within the range of from 50 °C to 200 °C,

7. The method for forming the organic semiconductor layer according to any of claims 1 to 6, wherein the weight average molecular weight of the organic semiconductive material is not more than 5,000.

8. The method for forming the organic semiconductor layer according to any of claims 1 to 7, wherein the organic semiconductive material is a compound having an alkylthiophene as the partial structure.

9. The method for forming the organic semiconductor layer according to any of claims 1 to 8, wherein the surface of the substrate on which the organic semiconductor layer has a contact angle to water of not less than 60°.

10. An organic thin film transistor having a gate electrode, a gate isolation layer, an organic semiconductor layer, a source electrode and a drain electrode on a substrate, wherein the organic semiconductor layer is formed by the method for forming an organic semiconductor layer described in any one of the above claims 1 through 9.
